Europäisches Patentamt

European Patent Office

Office européen des brevets

(19)

(11) Publication number: **0 088 004**
**A2**

(12) **EUROPEAN PATENT APPLICATION**

(21) Application number: **83400332.9**

(22) Date of filing: **16.02.83**

(51) Int. Cl.³: **C 30 B 11/00**

(30) Priority: **16.02.82 US 349395**

(43) Date of publication of application:
**07.09.83 Bulletin 83/36**

(84) Designated Contracting States:
**DE FR GB**

(71) Applicant: **THE BENDIX CORPORATION**
**Executive Offices Bendix Center**
**Southfield Michigan 48037(US)**

(72) Inventor: **Goetz, George Gabriel**
**4023 Huckleberry Row**
**Ellicott Maryland 21043(US)**

(74) Representative: **Brullé, Jean et al,**
**Service Brevets Bendix 44, rue François 1er**
**F-75008 Paris(FR)**

(54) Method for producing oriented islands of single crystal films.

(57) The invention is a method for producing a thin film semi-conductor material on an amorphous substrate (10) having a predetermined crystallographic orientation. The method includes forming a plurality of crystalline material islands (14) on the surface (18) of an amorphous substrate (10), forming a wall (20) around each island (14) of crystalline material with a material (16) having a higher melting temperature, then laser melting the crystalline material to promote the predetermined crystallographic orientation upon cooling. The walls (20) confine the thin layer of crystalline material (16) during laser melting, thereby preserving the straight edges and square corners necessary to promote the formation of the preferred crystallographic orientation upon cooling such as the (100) orientation of silicon.

FIG. 2

-1-

# METHOD FOR PRODUCING ORIENTED ISLANDS OF SINGLE CRYSTAL FILMS

## Background of the Invention

### Field of the Invention

The invention is related to a method for producing single crystal films on an amorphous substrate, and in particular to a method for producing silicon single crystal films having a preferred crystallographic orientation.

### Prior Art

Techniques for producing device-quality crystalline silicon films are being investigated by a number of laboratories. Much of the results are encouraging but it is evident that normally, a variety of crystal orientations are obtained on a single substrate. This is a problem because the threshold voltage of metal-oxide semiconductor (MOS) devices varies with the crystallographic orientation of the silicon film.

J. T. Gibbons and K. F. Lee in their article "C W Laser Recrystallization of (100) Si on Amorphous Substrates" Applied Physics Letters, Vol. 34, No. 12, June 15, 1979, pages 831-833, have shown that etching polycrystalline silicon films into small rectangular islands, typically 2 micrometers x 20 micrometers, can induce (100) orientation upon laser recrystallization. However, because the silicon is melted during the laser recrystallization process, it is difficult to maintain the edge and corner geometry that promotes the desired (100) orientation.

M. W. Geis et al in their article "Graphoepitaxy of Silicon on Fused Silica Using Surface Micropatterns and Laser Crystallization" Journal of Vacuum Science and Technology, Vol. 16, No. 6, December 1979, pages 1640-1643, have demonstrated that a pattern of grooves in the substrate, several microns wide and several tenths of a micron deep will also promote (100) orientation in laser crystalized silicon films. Subsequent tests, however, have shown that very sharp corners and very straight edges are required to obtain well oriented (100) films.

G. T. Coeloe et al in Massachusetts Institute of Technology, Memo 81-64, September 1981 entitled "Vertical Single Gate CMOS Inverters in Laser Processed Multilayer Substrates" and E. W. Maby et al in their article "MOSFET's on Silicon Prepared by Moing Melt Zone Recrystallization of Encapsulated Polycrystalline Silicon on an Insulated Substrate" disclose methods for recrystallizing a polycrystalline silicone film encapsulated by an overlayer of silicon dioxide and silicon nitride. Riseman in U.S. Patent 4,234,362 and Ho et al in U.S. Patent 4,209,350 disclose a technique for forming insulating layers on the sides of polycrystalline silicon deposited on the surface of a substrate. Similar processes are also disclosed by J. L. Deines et al in their article "process for Realization of submicron Geometries" I.B.M. Technical Disclosure Bulletin, Vol. 21, No. 9, February 1979, P. J. Tsang in his article "Method of Forming Side Contact", I.B.M. Technical Disclosure Bulletin, Vol. 22, No. 10, March 1980, and R. J. Miller in his article "High Density, Planar Metal Lands", I.B.M. Technical Disclosure Bulletin, Vol. 23, No. 6, November 1980.

Disclosed herein is a method for making small rectangular islands of polycrystalline silicon which can subsequently be crystallized with a laser inducing a (100) orientation. The method incorporates the teachings of Gibbons and Lee or Geise et al combined with the teachings of Horng et al, Riseman or Ho et al to produce small rectangular islands of crystalline silicon which do not deform under laser crystallization to promote (100) orientation, thereby enhancing (100) orientation with none of the limitations of the prior art.

-3-

## Brief Description of the Figures

Figure 1 is a cross sectional perspective showing the amorphous substrate with silicon islands formed thereon.

Figure 2 is a cross section showing the silicon nitride overlay.

Figure 3 is a cross section with the silicon nitride removed from the top surfaces of the silicon islands by sputtering or reactive ion etching.

Figure 4 is a flow diagram of the process.

## Summary of the Invention

The invention is a method for forming a plurality of crystalline islands on an amorphous substrate having a predetermined crystallographic orientation. The method comprises depositing a polycrystalline or amorphous silicon film over the surface of an amorphous substrate. The film is subdivided using high anisotropic reactive ion etching techniques into a plurality of rectangular islands, typically 4 to 20 micrometers ($\mu$ m) wide and 20 to 100 micrometers ($\mu$ m) long, having sidewalls perpendicular to the surface of the substrate. A thin layer of silicon nitride ($Si_3N_4$) is then deposited over the entire substrate using chemical-vapor deposition (CVD) or sputter deposition techniques. The thin film of silicon nitride covers the side walls as well as the top surface of the islands and the exposed surfaces of the substrate. The silicon nitride is then removed from the top surfaces of the polycrystalline or amorphous silicon islands and the surface of the substrate between the islands by sputtering or reactive ion etching leaving the silicon nitride layer only on the sidewalls of the islands. The polycrystalline or amorphous material is then melted with a scanning beam laser to promote crystallographic orientation upon cooling.

The advantage of the disclosed method is that the silicon nitride on the side walls of the islands confines the molten polycrystalline material during laser crystallization and maintains the straight sides and sharp corners necessary to promote the desired crystallographic orientation as it crystallizes upon cooling. This and other advantages of the disclosed process will become apparent from a reading of the detailed description of the invention and the appended drawings.

## Detailed Description of the Invention

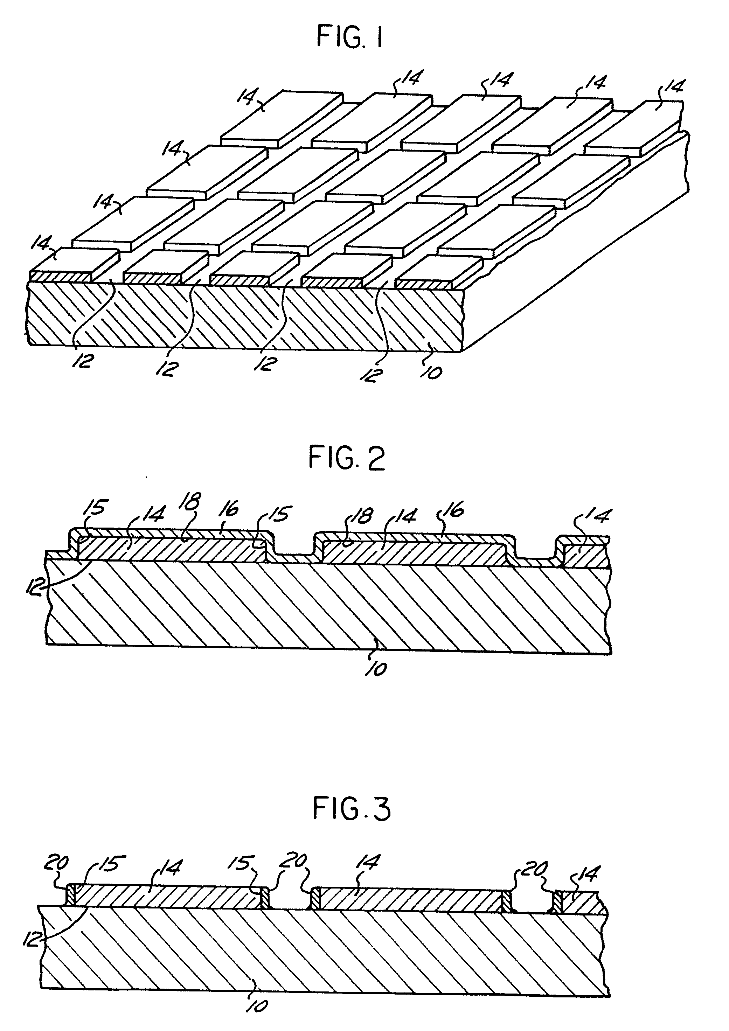

Referring to Figure 1, a polycrystalline silicon film between 0.4 and 0.7 (nominally 0.55) micrometers thick is deposited on a planar surface 12 of an amorphous substrate 10 such as silicon nitride ($Si_3N_4$) or silicom dioxide (SiO) wafer, using conventional deposition techniques. The polycrystalline silicon film is then anisotropically reactive ion etched to produce a plurality of rectangular silicon islands 14 having their side walls perpendicular to the substrate's surface 12 as shown in Figure 1. The rectangular silicon islands are typically 4 to 20 micrometers ($\mu$m) wide and 20 to 100 micrometers ($\mu$m) long. The islands are located where MOS devices are to be formed.

The surface 12 of the substrate 10 and the polycrystalline silicon islands 14 are then overlayed with a thin film of silicon nitride ($Si_3N_4$) 16 using sputtering or conventional chemical-vapor deposition (CVD) techniques. The thickness of the silicon nitride film 16 is about 1/5 the thickness of the silicon islands 14, or approximately 0.1 $\mu$m, and covers the side walls 15 and top surfaces 18 of the silicon islands as well as the exposed portions of the substrate's surface 12 between the silicon islands as shown in Figure 2.

The thin silicon nitride film 16 is then removed from the top surfaces 18 of the silicon islands 12 by bombarding these surfaces with ions or atoms in a direction perpendicular to the surfaces 12 and 18. The portion of the silicon nitride film 20 deposited on the side walls 15 of the polycrystalline islands 14 will not be removed because the ions are incident on the edge or verticle face of the film as shown on Figure 3. In fact the silicon nitride film 20 on the side walls 15 of the polycrystalline silicon islands 14 will slightly increase in thickness because some of the sputtered material from the substrate's surface 12 between the silicon islands will be redeposited on the side walls.

The polycrystalline or amorphous silicon islands 14 are then melted with a scanning laser beam to promote (100) orientation of their crystallographic structure upon cooling as disclosed by Gibbons and Lee in their article "C W Laser Recrystallization of Rectangular Si on Amorphous Substrates", Applied Physics Letters, Vol. 34, No. 12, June 15, 1979 and by Geise et al in their article "Graphoepitaxy of Silicon on Fused Silica using Surface Micropatterns and Laser Crystallization", Journal of Vacuum Science and Technology, Vol. 16, No. 6, December 1979. During the melting process with the scanning laser beam, the substrate may be heated to a predetermined temperature to reduce the laser energy required to melt the silicon film.

The melting temperature of the silicon nitride film 20 surrounding each silicon island 14 has a melting temperature approximately 500°C higher than the silicon. Therefore, during the laser annealing processes, the silicon nitride walls 20 will remain rigid, and confine the molten silicon during the laser crystallization step to maintain the straight side walls and sharp corners of the silicon islands 12. The straight edges and sharp corners promote crystallization in the (100) orientation as the silicon at the island edges behind the laser beam cool and solidify.

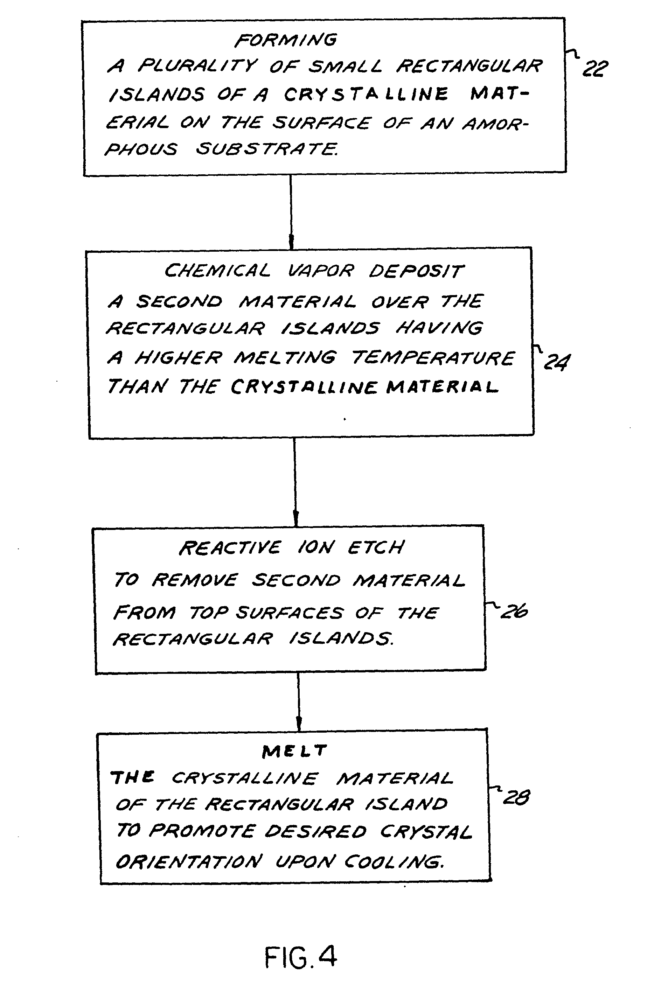

The flow diagram shown on Figure 4 illustrates the step-by-step of the disclosed processes. Referring to Figure 4, the process is initiated by forming a plurality of small rectangular islands of polycrystalline material on the surface of the substrate as indicated by block 22. The plurality of small rectangular islands may be formed by first depositing a thin layer of polycrystalline material, such as silicon, on an amorphous substrate, such as silicon oxide (quartz) or silicon nitride $(Si_3N_4)$. This thin film of polycrystalline material may then subdivide into the plurality of small rectangular islands with vertical edges using ion etching or any other method known in the art. The substrate containing the small rectangular islands is then overlayed with a second material having a melting temperature higher than the melting temperature of the polycrystalline material using sputtering or chemical-vapor deposition (CVD) techniques as indicated by block 24. The second material covers the side walls as well as the top surfaces of the rectangular islands and the exposed surfaces of the amorphous substrate between the islands. The assembly is then reactive ion etched to remove the second material from the top surfaces of the polycrystalline material leaving the second material deposited on the side walls of the rectangular islands intact as described in block 26. Finally the rectangular islands are recrystallized by laser melting to promote the desired crystallographic orientation of the polycrystalline material.

It is not intended to limit the disclosed process to promoting the (100) orientation of a thin film of polycrystalline silicon on an amorphous substrate. But rather, this process is applicable to any other polycrystalline material in which a preferred crystallographic orientation can be promoted by laser crystallization. Further, those skilled in the art will recognize that other materials may also be used in place of the silicon nitride for the second material without departing from the spirit of the invention as disclosed herein and set forth in the appended claims.

Claims:

1. A method for promoting a preferred crystal orientation of a thin polycrystalline film deposited on the surface of an amorphous substrate (10) characterized by the steps of:

forming a plurality of small rectangular islands (14) of crystalline material on a surface of the amorphous substrate (10);

depositing a second material (16) over said small rectangular islands (14) and the remaining exposed surface (12) of the amorphous substrate (10), said second material (16) having a higher melting temperature than said polycrystalline material;

reactive ion etching to remove said second material (16) from the top surface (18) of said rectangular islands (14); and

laser crystallizing said rectangular islands (14) of polycrystalline material to promote a preferred crystallographic orientation of said crystalline material.

2. The method of Claim 1 wherein said step of forming a plurality of small rectangular islands (14) includes the steps of:

depositing a thin film of crystalline material on a surface of the amorphous substrate (10); and

anisotropically reactive ion etching said thin film to produce said plurality of rectangular islands (14) having a top surface (18) parallel to said surface of the substrate (10) and side walls (15) perpendicular to said surface of the substrate (10).

3. The method of Claim 2 wherein said step of depositing a thin film of crystalline material comprises the step of chemical vapor depositing a thin film of polycrystalline silicon on said surface (12) of the amorphous substrate (10).

4. The method of Claim 3 wherein said thin film of silicon is deposited to a thickness ranging from 0.4 to 0.7 micrometers.

5. The method of Claim 2 wherein said step of depositing a thin film of crystalline material comprises the step of chemical-vapor depositing a thin film of polycrystalline material on said surface (12) of the substrate (10) having a thickness ranging from 0.4 to 0.7 micrometers.

6. The method of Claims 2 and 5 wherein said step of reactive ion etching to produce said plurality of rectangular island (14) produces small rectangular islands (14) between 4 and 20 micrometers wide and between 20 and 100 micrometers long.

7. The method of Claim 1 wherein said step of forming a plurality of small rectangular islands (14) forms a plurality of small rectangular islands (14) between 4 and 20 micrometers wide and between 20 and 100 micrometers long.

8. The method of Claim 4 wherein said step of anisotropic reactive ion etching produces small rectangular islands (14) of polycrystalline silicon between 4 and 20 micrometers wide and between 20 and 100 micrometers long.

9. The method of Claim 1 wherein said step of depositing a second material (16) comprises chemical-vapor depositing said second material (16).

10. The method of Claims 2 or 5 wherein said step of depositing a second material (16) comprises the step of chemical-vapor depositing a thin film of said second material (16) covering the top surface (18) and side walls (15) of said rectangular islands (14) and the exposed surface (12) of the amorphous substrate (10) between said islands.

11. The method of Claim 4 wherein said step of depositing a second material (16) comprises the step of chemical vapor depositing a thin film of said second material (16) covering the top surface (18) and side walls (15) of said rectangular islands (14) and the exposed surface (12) of the amorphous substrate (10) between said islands.

12. The method of Claims 1 and 9 wherein said step of depositing comprises the step of chemical-vapor depositing a thin film of silicon nitride.

13. The method of Claim 11 wherein said step of depositing comprises the step of chemical-vapor depositing a thin film of silicon nitride having a thickness approximately 1/5 the thickness of said crystalline material.

14. The method of Claim 1 wherein said step of reactive ion etching to remove said second material (16) comprises sputtering with ions that are perpendicularly incident to said surface (18) of the amorphous substrate (10) to remove said second material (16) from the top surfaces (18) of said islands.

15. The method of Claim 11 wherein said step of reactive ion etching comprises sputtering with ions that are perpendicularly incident to said surface (18) of the amorphous substrate (10) to remove said second material (16) from the top surfaces (18) of said islands (14).

16. The method of Claims 13 and 15 wherein said step of laser crystallizing comprises the step of laser scanning to melt the crystalline silicon islands (14) to promote (100) crystallographic orientation upon cooling.

17. The method of Claims 13 and 15 wherein said step of laser crystallizing comprises the steps of:

heating the amorphous substrate (10) to a predetermined temperature; and

heating the polycrystalline silicon thin film islands (14) to their melting temperature with scanning laser light to promote (100) crystallographic orientation upon cooling.

FIG. 1

FIG. 2

FIG. 3

```
┌─────────────────────────────────────────────┐
│              FORMING                          │
│   A PLURALITY OF SMALL RECTANGULAR            │──22
│   ISLANDS OF A CRYSTALLINE MAT-               │
│   ERIAL ON THE SURFACE OF AN AMOR-            │
│   PHOUS SUBSTRATE.                            │
└─────────────────────────────────────────────┘
                      │
                      ▼
┌─────────────────────────────────────────────┐
│        CHEMICAL VAPOR DEPOSIT                 │
│   A SECOND MATERIAL OVER THE                  │
│   RECTANGULAR ISLANDS HAVING                  │
│   A HIGHER MELTING TEMPERATURE               │──24
│   THAN THE CRYSTALLINE MATERIAL              │
└─────────────────────────────────────────────┘
                      │
                      ▼
┌─────────────────────────────────────────────┐
│          REACTIVE ION ETCH                    │
│   TO REMOVE SECOND MATERIAL                   │
│   FROM TOP SURFACES OF THE                    │──26
│   RECTANGULAR ISLANDS.                        │
└─────────────────────────────────────────────┘
                      │
                      ▼
┌─────────────────────────────────────────────┐
│              MELT                             │
│   THE CRYSTALLINE MATERIAL                    │
│   OF THE RECTANGULAR ISLAND                   │──28
│   TO PROMOTE DESIRED CRYSTAL                  │
│   ORIENTATION UPON COOLING.                   │
└─────────────────────────────────────────────┘
```

FIG.4